# FASCICULE DE BREVET EUROPEEN

(11) **EP 2 784 760 B1**
(45) Date de publication et mention de la délivrance du brevet: **05.05.2021**
(21) Numéro de dépôt: 14161573.2
(22) Date de dépôt: 25.03.2014
(51) Int. Cl.: G08B 3/10, G10K 9/20, G08B 29/18

(54) **Dispositif d'alarme sonore comprenant, dans une coque, une carte électronique et une sirène sonore**
Akustische Alarmvorrichtung, die eine Schutzschale, eine elektronische Karte und eine Alarmsirene umfasst
Acoustic alarm device comprising, in a shell, an electronic card and an acoustic siren

(30) Priorité: 26.03.2013 FR 1352714
(43) Date de publication de la demande: 01.10.2014
(73) Titulaire: Hager Security, 38920 Crolles (FR)
(72) Inventeur: Buiret, Jean-Luc, 38400 Saint Martin d'Heres (FR)
(74) Mandataire: Cabinet Nuss

(56) Documents cités:
- EP-A1- 1 881 469
- WO-A1-2012/176028
- WO-A2-2008/019402
- US-A- 6 166 623
- US-A1- 2012 182 137
- US-B1- 6 728 480

## Description

La présente invention concerne le domaine des boîtiers électroniques et plus spécialement le domaine des boîtiers incluant des blocs métalliques, tels que des sirènes sonores, des cartes électroniques portant des composants électroniques et éventuellement des piles.

Notamment lorsque de tels coffrets sont placés à l'extérieur des bâtiments, il se produit de la condensation à l'intérieur, qui engendre une détérioration des cartes électroniques et des composants électroniques, telle que leur fonctionnement est perturbé et leur durée de vie est limitée.

Le document WO 2008/019402 se rapporte à un système d'alarme portatif muni d'une coque, la coque étant munie dans sa paroi la plus basse d'un orifice d'évacuation d'eau (non représenté dans les figures).

Le document US 2012/0182137 A1 divulgue un dispositif d'alarme sonore selon le préambule de la revendication 1.

La présente invention a pour but de limiter cet inconvénient.

Il est proposé un dispositif d'alarme sonore selon la revendication 1.

Lesdites parois de guidage peuvent comprendre les parois extérieures du premier compartiment et/ou du second compartiment, au moins en partie.

Lesdites parois de guidage peuvent comprendre au moins une paroi interne sur laquelle le bloc métallique prend appui.

Le second compartiment peut comprendre un espace collecteur, ledit orifice d'évacuation étant aménagé de telle sorte que, dans ladite position d'installation, il est situé à la partie inférieure de cet espace collecteur.

Le dispositif proposé peut comprendre une coque qui comprend deux demi-coques présentant un plan de joint qui, dans ladite position d'installation, s'étend verticalement, le bloc métallique présentant un axe perpendiculaire à ce plan de joint et la carte électronique étant placée parallèlement à ce plan de joint.

Un joint périphérique d'étanchéité peut être interposé entre lesdites demi- coques.

Au moins l'une des demi-coques peut comprendre deux rebords périphériques adjacents, ledit orifice d'évacuation étant aménagé dans ces rebords.

La carte électronique et la sirène sonore peuvent être maintenues dans ladite coque par conjugaison de formes.

Il est également proposé un boîtier qui comprend un carter dans lequel est aménagé un espace de réception et de maintien par conjugaison de formes du dispositif d'alarme sonore tel que proposé ci-dessus.

Le carter peut comprendre deux demi-carters entre lesquels le dispositif électronique est maintenu par conjugaison de formes.

La coque du dispositif d'alarme sonore peut comprendre un logement extérieur de réception d'une pile électrique, le carter présentant une ouverture d'accès à ce logement

Ladite coque du dispositif d'alarme sonore et ledit carter peuvent délimiter entre eux un pavillon ou trompe acoustique ouvert vers l'extérieur.

Il est également proposé un coffret électronique qui comprend un boîtier tel que proposé ci-dessus et un socle, dans lequel le boîtier et le socle sont reliés par une articulation et comprennent entre eux un moyen de verrouillage du boîtier dans une position rapprochée du socle.

Le logement de réception d'une pile électrique peut être, dans ladite position rapprochée, ouvert du côté du socle.

Un coffret électronique selon la présente invention va maintenant être décrit à titre d'exemple non limitatif et illustré par le dessin sur lequel :
- la figure 1 représente une vue frontale de l'avant vers l'arrière d'un coffret, placé verticalement, comprenant un boîtier incluant un dispositif électronique et un socle ;
- la figure 2 représente une coupe horizontale selon II-II du coffret de la figure 1 ;
- la figure 3 représente une coupe verticale selon III-III du coffret de la figure 1 ;
- la figure 4 représente une vue frontale du coffret de la figure 1, un demi- carter avant du boîtier étant enlevé de façon à montrer une vue frontale du dispositif électronique, ce dernier étant quadrillé ;
- la figure 5 représente une coupe horizontale selon IV-IV du dispositif électronique précité, dans le même plan que la coupe horizontale de la figure 2 ;
- la figure 6 représente une coupe verticale selon IV-IV du dispositif électronique précité, dans le même plan que la coupe horizontale de la figure 2 ;
- la figure 7 représente une vue de l'arrière vers l'avant d'une demi- coque avant du dispositif électronique, ce dernier étant nu ;
- la figure 8 représente une vue de l'arrière vers l'avant de la demi- coque avant de la figure 7, équipée d'une carte électronique et d'une sirène ;
- la figure 9 représente une vue en perspective, côté intérieur, de la demi-coque arrière du dispositif électronique ;
- la figure 10 représente une vue en perspective, côté intérieur, d'une demi-coque avant du dispositif électronique ; et
- la figure 11 représente une vue arrière de la demi- coque arrière du dispositif électronique.

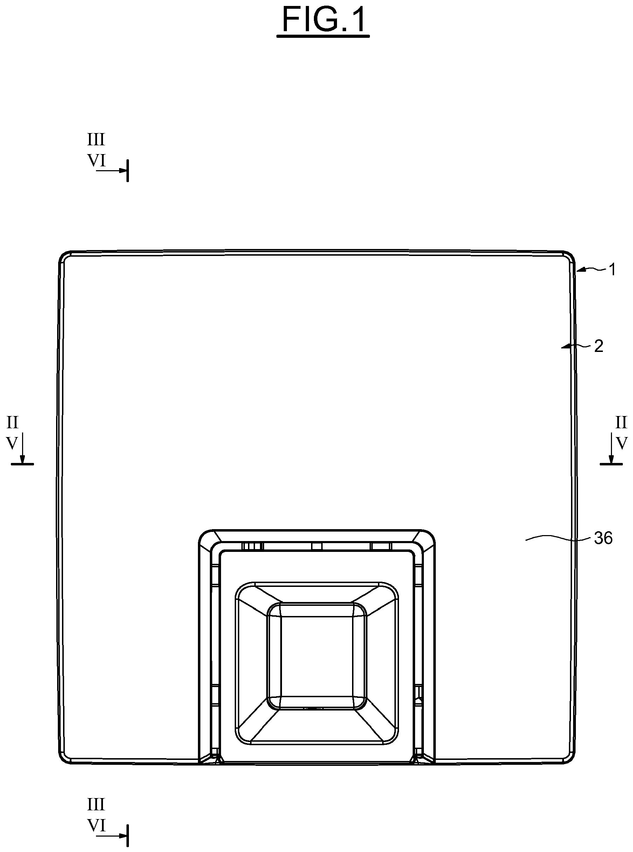

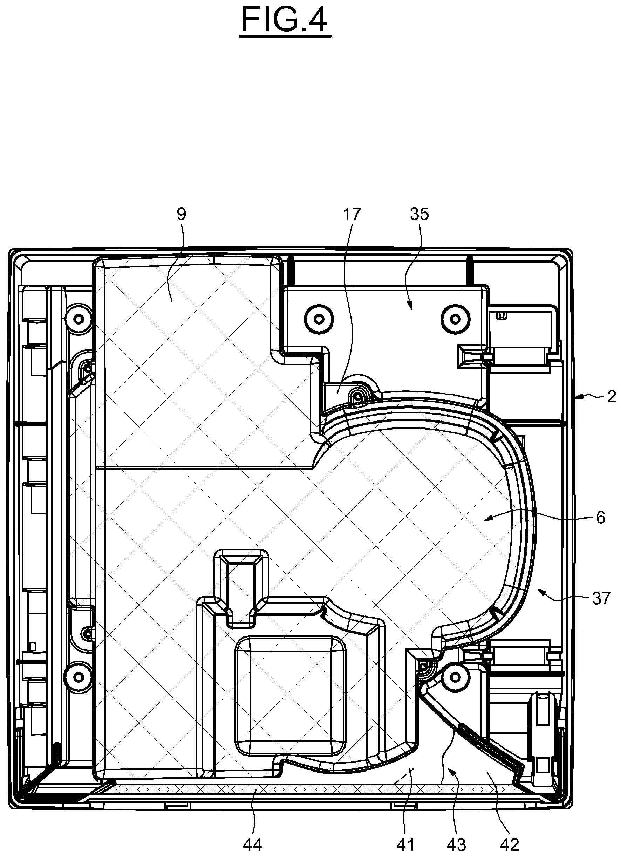

Comme illustré sur les figures 1 à 4, un coffret 1 comprend un boîtier 2 monté sur un socle 3 par l'intermédiaire d'une charnière latérale 4, le boîtier 2 et le socle 3 étant munis latéralement, à l'opposé de la charnière 4, d'un moyen de verrouillage 5 tel qu'un verrou ou une gâche, pour maintenir le boîtier 2 dans une position rapprochée au-dessus du socle 3.

A l'intérieur du boîtier 2 est installé un dispositif d'alarme sonore 6.

Dans la description qui suit, il va être considéré que le coffret 1 est disposé dans une position verticale d'installation dans laquelle, par exemple, le socle 2 est fixé à plat contre un mur et le boîtier s'étend devant et en appui sur le socle 3, l'axe de la charnière 4 étant vertical. Il va également être considéré que l'arrière du coffret 1 est du côté du mur et que l'avant est à distance du mur et que le dispositif d'alarme sonore 6 est placé verticalement à l'intérieur du boîtier 2.

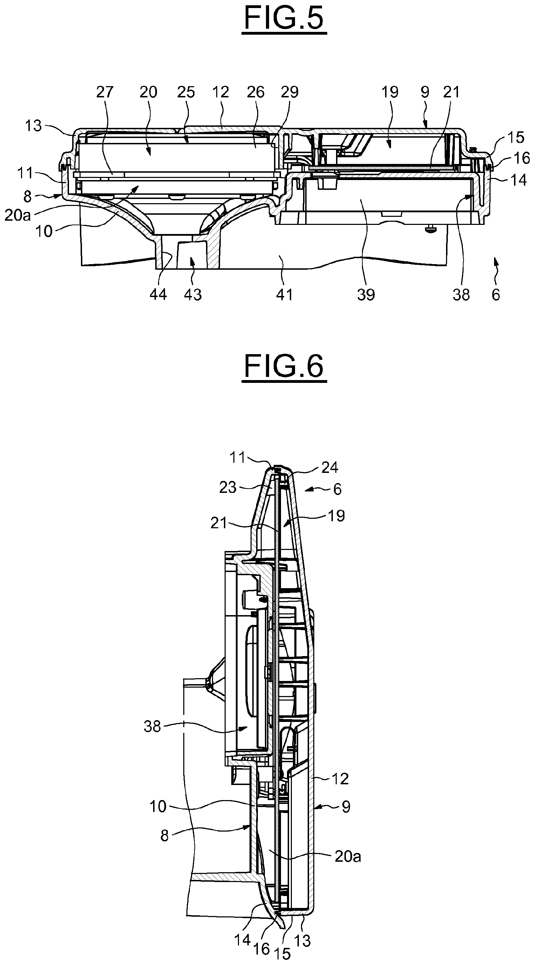

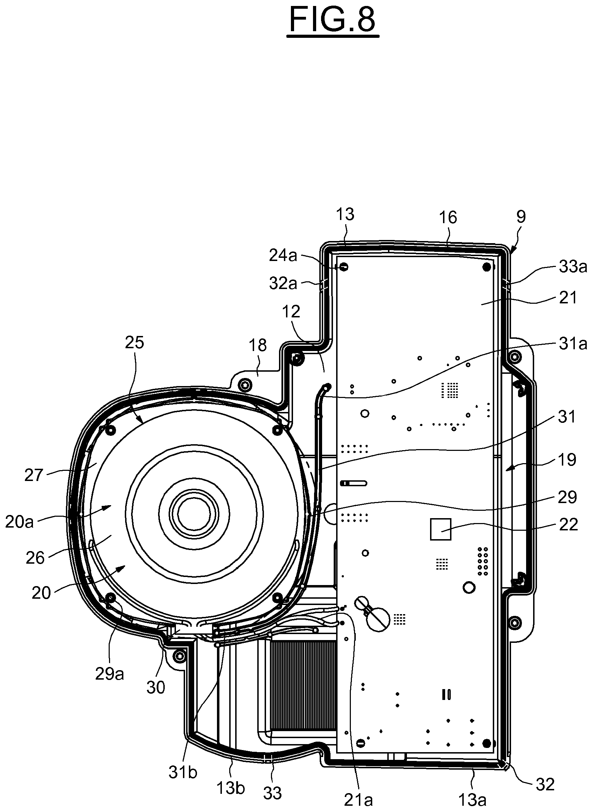

En se reportant en particulier aux figures 5 à 10, on va tout d'abord décrire un dispositif d'alarme sonore 6.

Comme illustré en particulier sur les figures 5, 6, 9 et 10, le dispositif d'alarme sonore 6 comprend une coque extérieure 7, par exemple en une matière plastique, qui comprend une demi-coque arrière 8 et une demi-coque avant 9.

La demi-coque arrière 8 comprend une paroi extérieure arrière 10 et un pourtour extérieur 11 qui s'étend vers l'avant et la demi- coque avant 9 comprend une paroi extérieure avant 12 et un pourtour extérieur 13 qui s'étend vers l'arrière. Les pourtours extérieurs 11 et 13 s'étendent l'un vers l'autre et présentent des rebords adjacents 14 et 15 en appui l'un sur l'autre par l'intermédiaire d'un joint périphérique d'étanchéité 16, selon un plan de joint vertical.

Les pourtours 11 et 13 des demi-coques 8 et 9 présentent, extérieurement, une pluralité de portions en saillie 17 et 18 en vis-à- vis qui peuvent être reliées par l'intermédiaire de vis de fixation n permettant d'accoupler les demi- coques 8 et 9 en pressant le joint périphérique d'étanchéité 16.

Les deux demi-coques 8 et 9 délimitent entre elles un premier compartiment 19 et un second compartiment 20 qui sont formés, horizontalement, l'un à côté de l'autre et qui communiquent entre eux horizontalement.

Le premier compartiment 19 est, verticalement, substantiellement rectangulaire.

Le second compartiment 20 présente une première partie 20 a substantiellement cylindrique et aménagée sensiblement à mi- hauteur du premier compartiment 19 et une seconde partie 20 b formant un espace collecteur qui est, verticalement, substantiellement rectangulaire, et qui prolonge vers le bas la première partie 20 a jusqu'au bas du premier compartiment 19.

Les parties 20 a et 20 b du compartiment 20 communiquent horizontalement avec le premier compartiment 19.

A l'intérieur du premier compartiment 19 est installée une carte électronique 21 qui portent des composants électronique 22. Cette carte électronique 21 est disposée verticalement, substantiellement parallèlement aux parois 10 et 12 des demi- coques 8 et 9 et occupe presque toute la surface verticale du premier compartiment 19.

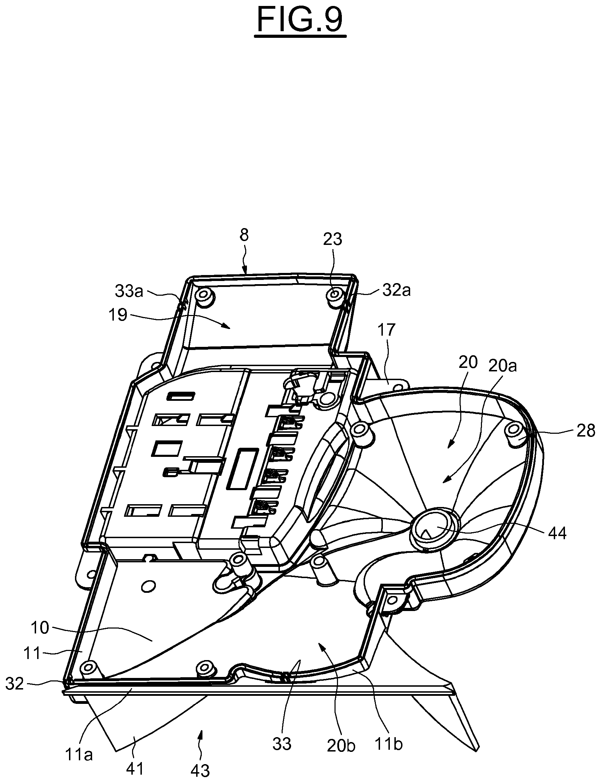

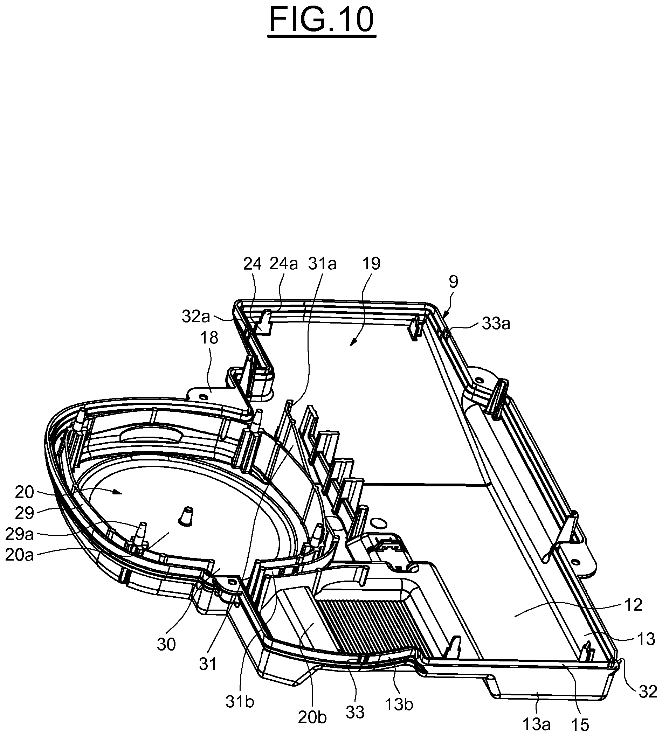

Les coins de la carte électronique 21 sont pris entre des plots internes 23 et 24 des demi-coques, en saillie sur les parois 10 et 12 de ces dernières (figures 9 et 10), les extrémités 24a de sections réduites des plots 24 traversant des trous de positionnement de la carte électronique 21 et pénétrant dans les plots 23. La carte électronique 21 est ainsi maintenue par conjugaison de formes et est suspendue à l'intérieur du premier compartiment 19.

A l'intérieur du second compartiment 20 est installée une sirène sonore 25 qui comprend un bloc-moteur métallique cylindrique 26 dont l'axe est disposé perpendiculairement aux parois 10 et 12 des demi- coques 8 et 9 et occupe presque tout le volume de la première partie 20a du second compartiment 20, en étant à distance, horizontalement, de la carte électronique 21.

Le bloc-moteur métallique cylindrique 26 de la sirène sonore 25 présente un rebord périphérique 27 qui est pris entre d'une part des plots internes 28 (figure 9), par exemple au nombre de quatre disposés à 90°, en saillie sur la paroi 10 de la demi-coque 8, et d'autre part une paroi interne annulaire 29, en saillie sur la paroi 12 de la demi- coque 9 (figure 10). Cette paroi interne annulaire 29 est munie de doigts en saillie 29a traversant des trous de centrage du rebord périphérique 27 et engagés dans les plots en saillie 28. La sirène sonore 25 est ainsi maintenue par conjugaison de formes et est suspendue à l'intérieur du second compartiment 20.

La paroi interne annulaire 29 présente un passage d'évacuation 30 aménagé au travers de sa partie inférieure.

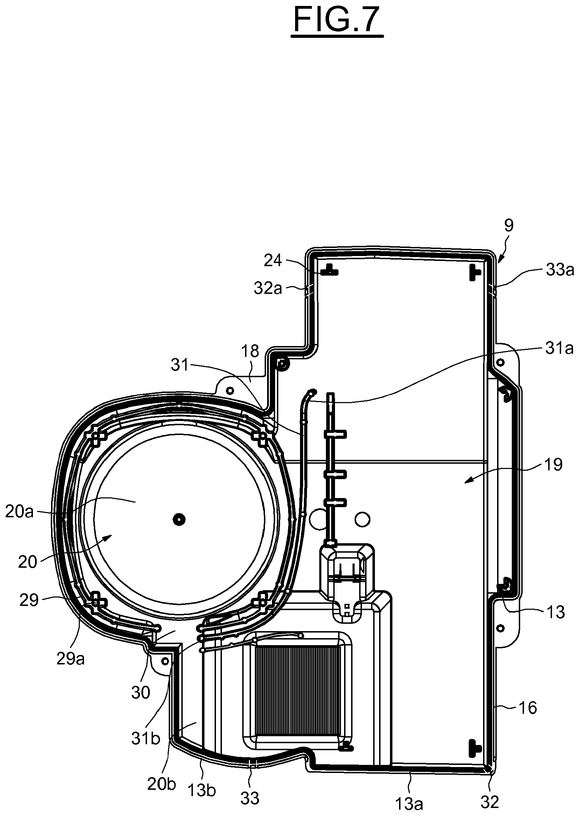

Comme illustré sur les figures 7, 8 et 10, la paroi 12 de la demi-coque 9 comprend une paroi interne intermédiaire en saillie 31 qui s'étend substantiellement entre les compartiments 19 et 20, plus particulièrement entre la carte électronique 21 et le bloc-moteur métallique cylindrique 26 de la sirène sonore 25 pour former une barrière, vers la paroi 10 de la demi-coque 8, en laissant subsister un passage de communication. L'extrémité supérieure 31a de la paroi i interne 31 est placée de façon à laisser subsister un passage de communication. L'extrémité inférieure 31b de la paroi interne 31 est recourbée de façon à s'étendre, de façon inclinée vers le bas, dans la partie inférieure 20b du second compartiment 20.

La carte électronique 21 est reliée à la sirène sonore 25 par l'intermédiaire de fils électriques 21a.

La portion 11a du pourtour 11 de la demi-coque 8 et la portion 13a du pourtour 13 de la demi-coque 9, situées au-dessous du premier compartiment 19, sont par exemple plates et présentent des orifices traversants d'évacuation 32 aménagés dans leurs rebords et traversés par le joint d'étanchéité 16 (figures 7, 8, 9 et 10).

La portion 11b du pourtour 11 de la demi-coque 8 et la portion 13b du pourtour 13 de la demi-coque 9, situées au-dessous de la partie inférieure 20b du second compartiment 20, sont intérieurement concaves vers le haut et présentent des orifices traversants d'évacuation 33 à leurs parties inférieures, aménagés dans leurs rebords et traversés par le joint d'étanchéité 16 (figures 7, 8, 9 et 10).

Les pourtours 11 et 13 présentent en outre, dans la partie supérieure du premier compartiment 19, des orifices traversants d'aération 32a et 33a, aménagés dans leurs rebords et traversés par le joint d'étanchéité 16 (figures 7, 8, 9 et 10).

Les faces internes des parois 10 et 12 et des pourtours 11 et 13 des demi-coques 8 et 9, les faces de la paroi interne annulaire 29 et les faces de la paroi interne intermédiaire 31 sont formées et orientées de façon à constituer des parois de guidage d'écoulement de telle sorte que, dans la position d'installation décrite ci-dessus, un liquide de condensation, généralement de l'eau, déposé sur ces parois de guidage s'écoule vers le bas et soit évacué par les orifices d'évacuation 32 et 33.

Plus précisément, d'une part le liquide de condensation apparaissant dans le premier compartiment 19 est préférentiellement évacué par les orifices d'évacuation 32 et, d'autre part le liquide de condensation apparaissant dans le second compartiment 20 et apparaissant sur la paroi interne intermédiaire 31 est préférentiellement évacué par les orifices d'évacuation 33.

La sirène sonore 25 située dans le second compartiment 20 constitue, grâce à son bloc-moteur métallique volumineux 26, une pompe de condensation apte à attirer l'humidité présente dans le premier compartiment 19, dans lequel se trouve la carte électronique portant les composants électriques 22, vers le second compartiment 20.

Ainsi, la plus grande partie de l'humidité présente dans la coque 7 se condense préférentiellement dans le second compartiment et est évacuée par les orifices d'évacuation 33 situés à la partie inférieure de ce second compartiment 20. De plus, du fait que la sirène sonore 25 comprenant le bloc-moteur métallique 26 est décalée horizontalement par rapport à la carte électronique 21, le liquide de condensation s'écoulant dans le second compartiment 20 ne risque pas de rencontrer la carte électronique 21 et les composants électroniques qu'elle porte. En conséquence, la carte électronique 21 et les composants électriques 22 sont pour l'essentiel protégés contre l'humidité.

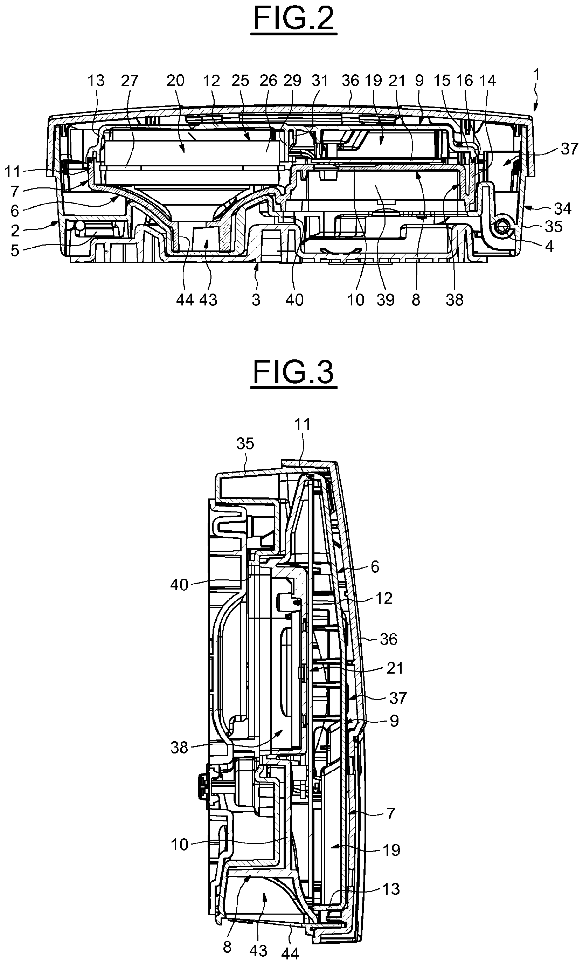

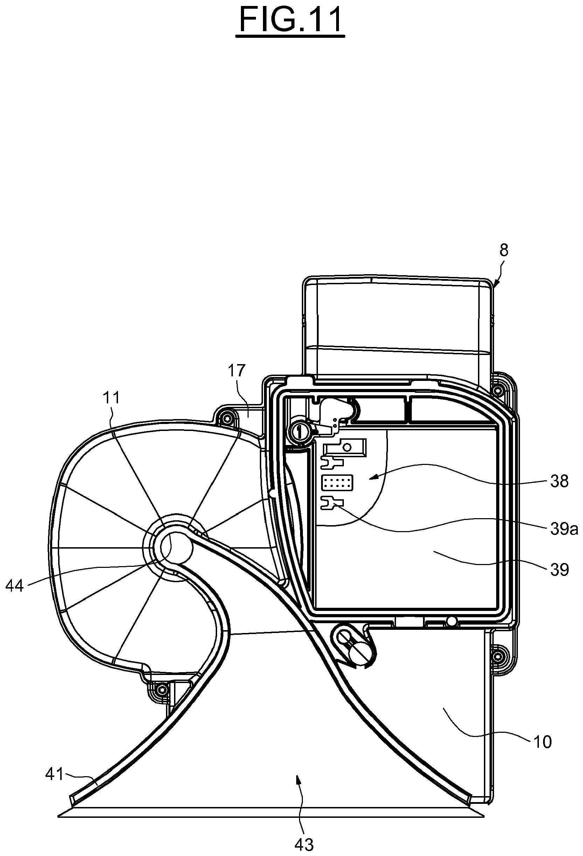

En se reportant aux figures 2, 3, 4 et 11, on va maintenant décrire le boîtier 2.

Le boîtier 2 est, de forme générale extérieure, parallélépipédique et comprend un carter 34 qui comprend un demi- carter arrière 35 et un demi-carter avant 36, qui délimite un espace 37 de réception du dispositif d'alarme sonore 6. Les demi- carters 35 et 36 présentent des formes complémentaires à des formes de la coque 7 du dispositif d'alarme sonore 6 et en appui les unes sur les autres de telle sorte que le dispositif d'alarme sonore 6 est maintenu dans l'espace de réception 37 du boîtier 2 par conjugaison de formes lorsque les demi- carters 35 et 36 sont accouplés et maintenus par exemple par des vis engagées par l'arrière au travers du demi-carter arrière 35 et en prise avec le demi-carter avant 36.

La demi- coque arrière 8 de la coque 7 du dispositif d'alarme sonore 6 présente, à l'arrière, un logement 38 ouvert vers l'arrière, situé en arrière du premier compartiment 19, dans lequel peut être installée une pile électrique 39 d'alimentation de la carte électronique 21 par l'intermédiaire de connexions électriques 39a traversant la paroi arrière 10 de la demi-coque arrière 8.

Le demi-carter arrière 35 présente une ouverture 40 d'accès au logement 38 (figure 2), au travers de laquelle la pile électrique 39 peut être mise en place ou extraite du logement 38 lorsque le boîtier 2 est séparé ou écarté par pivotement du socle 3 selon la charnière 4.

La demi- coque arrière 8 de la coque 7 du dispositif d'alarme sonore 6 présente en outre, à l'arrière en saillie sur sa paroi arrière 10, une paroi en saillie 41 s'étendant vers une paroi arrière 42 du demi-carter arrière 35, de façon à délimiter avec ce dernier un pavillon ou trompe acoustique 43 dont le sommet est relié au second compartiment

20 de la coque 7 du dispositif d'alarme sonore 6 au travers d'un trou traversant 44 aménagé au travers de la paroi arrière 10 de la demi-coque arrière 8, en face de l'orifice de sortie sonore de la sirène sonore 25 (figures 2 et 5). Le pavillon ou trompe acoustique 43 est ouvert vers le bas.

Le carter 34 présente une grille inférieure 45 en face de l'extrémité inférieure du pavillon ou trompe acoustique 43.

Avantageusement, le liquide de condensation issu du dispositif d'alarme sonore 6 comme décrit précédemment peut s'écouler au travers de la grille 45.

La présente invention ne se limite pas à l'exemple ci-dessus décrit. Bien des variantes de réalisation sont possibles sans sortir du cadre de l'invention telle que définie par les revendications.

## Revendications

1. Dispositif d'alarme sonore comprenant une coque dans laquelle sont aménagés un premier compartiment (19) dans lequel est installée une carte électronique (21) portant des composants électroniques et un second compartiment (20) voisin du premier compartiment et dans lequel est installée une sirène sonore (25), dispositif dans lequel les compartiments (19, 20) comprennent des parois de guidage d'écoulement (10, 11, 12, 13, 29, 31), dont au moins une paroi interne intermédiaire de guidage (31) aménagée entre lesdits compartiments, orientées de telle sorte que, lorsque le dispositif est disposé verticalement dans une position d'installation, les compartiments (19, 20) sont horizontalement l'un à côté de l'autre, un liquide de condensation déposé sur ces parois de guidage s'écoule vers le bas et est évacué par au moins un orifice d'évacuation (32, 33) aménagé au travers de la coque, ledit dispositif étant **caractérisé en ce que** : la paroi interne intermédiaire de guidage (31) aménagée entre lesdits compartiments laisse subsister un passage de communication entre ces compartiments, et **en ce que**
la sirène (25) comprend un bloc métallique (26) qui se présente sous la forme d'un bloc-moteur métallique volumineux, la sirène (25) constituant, grâce à ce bloc-moteur métallique volumineux (26), une pompe de condensation apte à attirer l'humidité présente dans le premier compartiment (19) vers le second compartiment (20).

2. Dispositif selon la revendication 1, dans lequel lesdites parois de guidage comprennent les parois extérieures du premier compartiment (19) et du second compartiment (20), au moins en partie.

3. Dispositif selon la revendication 1, dans lequel lesdites parois de guidage comprennent au moins une paroi interne (29) sur laquelle le bloc métallique (26) prend appui.

4. Dispositif selon la revendication 1, dans lequel le second compartiment comprend un espace collecteur (20b), ledit orifice d'évacuation (33) étant aménagé de telle sorte que, dans ladite position d'installation, il est situé à la partie inférieure de cet espace collecteur.

5. Dispositif selon l'une quelconque des revendications précédentes, comprenant une coque extérieure (7) qui comprend deux demi-coques (8, 9) présentant un plan de joint qui, dans ladite position d'installation, s'étend verticalement, le bloc métallique (26) présentant un axe perpendiculaire à ce plan de joint et la carte électronique (21) étant placée parallèlement à ce plan de joint.

6. Dispositif selon la revendication 5, dans lequel un joint périphérique d'étanchéité est interposé entre lesdites demi-coques.

7. Dispositif selon l'une quelconque des revendications 5 et 6, dans lequel au moins l'une des demi-coques comprend deux rebords périphériques adjacents, ledit orifice d'évacuation (32) étant aménagé dans ces rebords.

8. Dispositif selon l'une quelconque des revendications précédentes, dans lequel la carte électronique (21) et la sirène sonore (26) sont maintenues dans ladite coque (7) par conjugaison de formes.

9. Boîtier (2) comprenant un carter (34) dans lequel est aménagé un espace (37) de réception et de maintien par conjugaison de formes du dispositif d'alarme sonore (6) selon l'une quelconque des revendications précédentes, le boîtier (2) comprenant ledit dispositif d'alarme sonore (6) dans ledit espace (37).

10. Boîtier selon la revendication 9, dans lequel le carter comprend deux demi-carters (35, 36) entre lesquels le dispositif d'alarme sonore (6) est maintenu par conjugaison de formes.

11. Boîtier selon l'une des revendications 9 et 10, dans lequel la coque (7) du dispositif d'alarme sonore (6) comprend un logement extérieur (38) de réception d'une pile électrique (39), le carter présentant une ouverture (40) d'accès à ce logement.

12. Boîtier selon l'une quelconque des revendications 9 à 11, dans lequel ladite coque (7) du dispositif d'alarme sonore et ledit carter (34) délimitent entre eux un pavillon ou trompe acoustique (43) ouvert vers l'extérieur.

13. Coffret électronique (1) comprenant un boîtier selon l'une quelconque des revendications 9 à 12 et un socle (3), dans lequel le boîtier (2) et le socle (3) sont reliés par une articulation (4) et comprennent entre eux un moyen de verrouillage (5) du boîtier dans une position rapprochée du socle.

14. Coffret selon la revendication 13, dans lequel le logement (38) de réception d'une pile électrique (39) est, dans ladite position rapprochée, ouvert du côté du socle (3).

## Patentansprüche

1. Akustische Alarmvorrichtung, die eine Schale enthält, in der ein erstes Abteil (19), in das eine elektronische Bauteile tragende Elektronikkarte (21) eingebaut ist, und ein zweites Abteil (20) eingerichtet sind, das dem ersten Abteil benachbart ist und in das eine akustische Sirene (25) eingebaut ist, Vorrichtung, in der die Abteile (19, 20) Strömungsleitwände (10, 11, 12, 13, 29, 31) enthalten, von denen mindestens eine innere Zwischenleitwand (31) zwischen den Abteilen eingerichtet ist, die so ausgerichtet sind, dass, wenn die Vorrichtung in einer Einbauposition senkrecht angeordnet ist, die Abteile (19, 20) waagrecht nebeneinander liegen, eine auf diese Leitwände aufgebrachte Kondensationsflüssigkeit nach unten strömt und durch mindestens eine Abfuhröffnung (32, 33) abgeführt wird, die durch die Schale hindurch angebracht ist,
wobei die Vorrichtung **dadurch gekennzeichnet ist, dass**: die zwischen den Abteilen angeordnete innere Zwischenleitwand (31) einen Kommunikationsdurchgang zwischen diesen Abteilen fortbestehen lässt, und dass die Sirene (25) einen metallischen Block (26) enthält, der in Form eines voluminösen metallischen Motorblocks vorliegt, wobei die Sirene (25) mittels dieses voluminösen metallischen Motorblocks (26) eine Kondensatpumpe bildet, die die im ersten Abteil (19) vorhandene Feuchtigkeit zum zweiten Abteil (20) anziehen kann.

2. Vorrichtung nach Anspruch 1, wobei die Leitwände zumindest zum Teil die Außenwände des ersten Abteils (19) und des zweiten Abteils (20) enthalten.

3. Vorrichtung nach Anspruch 1, wobei die Leitwände mindestens eine Innenwand (29) enthalten, auf der der metallische Block (26) aufliegt.

4. Vorrichtung nach Anspruch 1, wobei das zweite Abteil einen Sammelraum (20b) enthält, wobei die Abfuhröffnung (33) so eingerichtet ist, dass sie sich in der Einbaustellung im unteren Teil dieses Sammelraums befindet.

5. Vorrichtung nach einem der vorhergehenden Ansprüche, die eine Außenschale (7) enthält, die zwei Halbschalen (8, 9) enthält, die eine Verbindungsebene aufweisen, die sich in der Einbaustellung senkrecht erstreckt, wobei der metallische Block (26) eine Achse lotrecht zu dieser Verbindungsebene aufweist und die Elektronikkarte (21) parallel zu dieser Verbindungsebene platziert ist.

6. Vorrichtung nach Anspruch 5, wobei eine Umfangsdichtung zwischen die Halbschalen eingefügt ist.

7. Vorrichtung nach einem der Ansprüche 5 und 6, wobei mindestens eine der Halbschalen zwei benachbarte Umfangsrandleisten enthält, wobei die Abfuhröffnung (32) in diesen Randleisten eingerichtet ist.

8. Vorrichtung nach einem der vorhergehenden Ansprüche, wobei die Elektronikkarte (21) und die akustische Sirene (26) durch Formvereinigung in der Schale (7) gehalten werden.

9. Gehäuse (2), das eine Wanne (34) enthält, in der ein Raum (37) zum Empfang und zum Halt durch Formvereinigung der akustischen Alarmvorrichtung (6) nach einem der vorhergehenden Ansprüche eingerichtet ist, wobei das Gehäuse (2) die akustische Alarmvorrichtung (6) in dem Raum (37) enthält.

10. Gehäuse nach Anspruch 9, wobei die Wanne zwei Halbwannen (35, 36) enthält, zwischen denen die akustische Alarmvorrichtung (6) durch Formvereinigung gehalten wird.

11. Gehäuse nach einem der Ansprüche 9 und 10, wobei die Schale (7) der akustischen Alarmvorrichtung (6) eine äußere Aufnahme (38) zum Empfang einer elektrischen Batterie (39) enthält, wobei die Wanne eine Zugangsöffnung (40) zu dieser Aufnahme aufweist.

12. Gehäuse nach einem der Ansprüche 9 bis 11, wobei die Schale (7) der akustischen Alarmvorrichtung und die Wanne (34) zwischen sich einen nach außen offenen Schalltrichter oder Schallhorn (43) begrenzen.

13. Elektronikkasten (1), der ein Gehäuse nach einem der Ansprüche 9 bis 12 und einen Sockel (3) enthält, wobei das Gehäuse (2) und der Sockel (3) durch ein Gelenk (4) verbunden sind und zwischen sich eine Verriegelungseinrichtung (5) des Gehäuses in einer angenäherten Stellung des Sockels enthalten.

14. Kasten nach Anspruch 13, wobei die Aufnahme (38) zum Empfang einer elektrischen Batterie (39) in der angenäherten Stellung auf der Seite des Sockels (3) offen ist.

## Claims

1. Audible alarm device comprising a shell in which are arranged a first compartment (19) in which is installed a circuit board (21) bearing electronic components and a second compartment (20), adjacent to the first compartment, in which is installed an audible siren (25), in which device the compartments (19, 20) comprise flow guide walls (10, 11, 12, 13, 29, 31), including at least one intermediate internal guide wall (31) arranged between said compartments, which walls are oriented such that, when the device is arranged vertically in an installation position, the compartments (19, 20) are horizontally next to one another, and a condensate liquid deposited on these guide walls flows downwards and is discharged via at least one discharge opening (32, 33) made through the shell, said device being **characterized in that**:
the intermediate internal guide wall (31) arranged between said compartments leaves a communication passage between these compartments, and **in that** the siren (25) comprising a metal block (26) that takes the form of a bulky metal motor block, the siren (25) forming, by virtue of this bulky metal motor block (26), a condensate pump able to draw the moisture present in the first compartment (19) into the second compartment (20).

2. Device according to Claim 1, wherein said guide walls comprise the outer walls of the first compartment (19) and of the second compartment (20), at least in part.

3. Device according to Claim 1, wherein said guide walls comprise at least one internal wall (29) on which the metal block (26) rests.

4. Device according to Claim 1, wherein the second compartment comprises a collecting space (20b), said discharge opening (33) being made such that, in said installation position, it is located in the lower portion of this collecting space.

5. Device according to any one of the preceding claims, comprising an outer shell (7) that comprises two half-shells (8, 9) having a parting line which, in said installation position, extends vertically, the metal block (26) having an axis perpendicular to this parting line and the circuit board (21) being placed parallel to this parting line.

6. Device according to Claim 5, wherein a peripheral seal is interposed between said half-shells.

7. Device according to either one of Claims 5 and 6, wherein at least one of the half-shells comprises two adjacent peripheral rims, said discharge opening (32) being made in these rims.

8. Device according to any one of the preceding claims, wherein the circuit board (21) and the audible siren (26) are held in said shell (7) by mating of shapes.

9. Housing (2) comprising a casing (34) in which is provided a space (37) for accommodating and holding, by mating of shapes, the audible alarm device (6) according to any one of the preceding claims, the housing (2) comprising said audible alarm device (6) in said space (37).

10. Housing according to Claim 9, wherein the casing comprises two half-casings (35, 36) between which the audible alarm device (6) is held by mating of shapes.

11. Housing according to one of Claims 9 and 10, wherein the shell (7) of the audible alarm device (6) comprises an outer accommodation (38) for accommodating an electric battery cell (39), the casing having an aperture (40) for accessing this accommodation.

12. Housing according to any one of Claims 9 to 11, wherein said shell (7) of the audible alarm device and said casing (34) define between them an acoustic horn (43) that is open to the outside.

13. Electronic box (1) comprising a housing according to any one of Claims 9 to 12 and a base (3), wherein the housing (2) and the base (3) are connected by an articulation (4) and comprise between them a means (5) for locking the housing in a proximal position with respect to the base.

14. Box according to Claim 13, wherein the accommodation (38) for accommodating an electric battery cell (39) is, in said proximal position, open on the side of the base (3).
